# EUROPEAN PATENT SPECIFICATION

(11) **EP 1 063 736 B1**
(45) Date of publication and mention of the grant of the patent: **01.08.2007**
(21) Application number: 00106865.9
(22) Date of filing: 30.03.2000
(51) Int. Cl.: H01R 43/02

(54) **Electrical connector and method of soldering cable to such a connector**
Elektrischer Verbinder und Verfahren zum Anlöten eines Kabels
Connecteur électrique et procédé de soudage d'un câble sur le connecteur

(30) Priority: 23.06.1999 JP 17679999
(43) Date of publication of application: 27.12.2000
(73) Proprietor: HIROSE ELECTRIC CO., LTD., Shinagawa-ku Tokyo (JP)
(72) Inventor: Funatsu, Akira, c/o Hirose Electric Co., Ltd., Tokyo (JP)
(74) Representative: Pätzold, Herbert

(56) References cited:
- EP-A- 0 886 338
- US-A- 4 090 656
- US-A- 5 129 573

## Description

The present invention relates to electrical connectors and methods of soldering cables to connectors.

Connectors having a plurality of terminals whose connection sections are arranged on the terminal arranging faces of the insulating housing are well known. The flat connection sections are arranged closely to each other and soldered to the core wires of cables. For example, predetermined lengths of insulation sheath are removed from the end portions of a ribbon cable to expose respective core wires, and either (1) cream solder is applied to the core wires, which are then arranged on the connection sections or (2) cream solder is applied manually to the connection sections, on which the core wires are arranged, and the cream solder is heated to solder the connection sections and the core wires.

However, in the above method (1), it is frequent that the amount of cream solder applied is not satisfactory. Especially, the core wires are thin, the problem arises more frequently, resulting in the poor soldering. In the method (2), it takes much labor to apply cream solder to the respective connection sections. If automated, the equipment is too complicated to be economical. In addition, cream solder can flow into a space between adjacent connection sections, making a short-circuit.

A connector known in the art is disclosed in document EP-A-0 886 338.

Accordingly, it is an object of the invention to provide an electrical connector capable of ensuring that a satisfactory amount of cream solder is applied to each core wire without the danger of making a short-circuit between adjacent connection sections.

The above object is achieved by the invention as claimed in claim 1.

Embodiments of the invention will now be described by way of example with reference to the accompanying drawings, in which:
Fig. 1 is a top plan view of a cable and an electrical connector according to an embodiment of the invention;
Fig. 2 is a sectional view taken along line II-II of Fig. 1;
Figs. 3A-E are sectional views showing a process of soldering the cable to the connector;
Fig. 4 is a sectional view of an electrical connector according to another embodiment of the invention; and
Fig. 5 is a top plan view of an electrical connector according to still another embodiment of the invention.

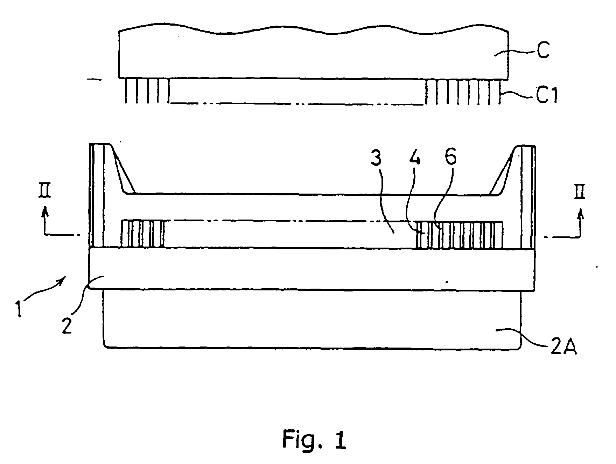

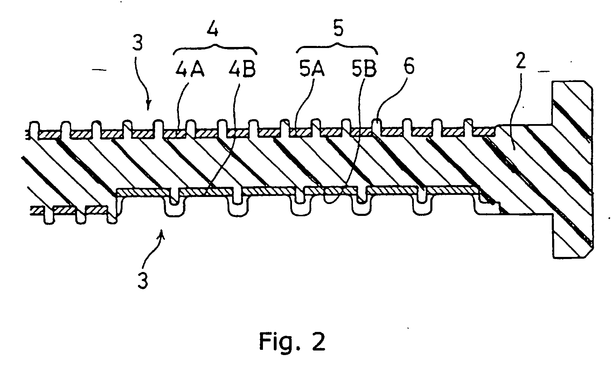

In Fig. 1, a connector 1 comprises a housing 2 of a dielectric material and a plurality of terminals provided in the housing 2. The housing 2 has a front plugging section 2A for receiving a mating connector and a pair of parallel terminal arranging faces 3 on upper and lower surfaces of the rear housing portion. A plurality of ribs 6 extend in the plugging direction to form grooves 5 (Fig. 2) for receiving connection sections 4 of the terminals.

The connection sections 4 are made flat such that they are placed on the bottoms of the grooves 5.

In Fig. 2, the ribs 6 are arranged so as to provide narrow grooves 5A in the upper face and a half of the lower face of the housing 2 for receiving the connection sections 4A of narrow signal terminals and wide grooves 5B in the other half of the lower face for receiving the connection sections 4B of wide power terminals.

A cable is soldered to the connection sections 4 of terminals as follows. The signal and power terminals are soldered in the same way so that only the signal terminals will be described.

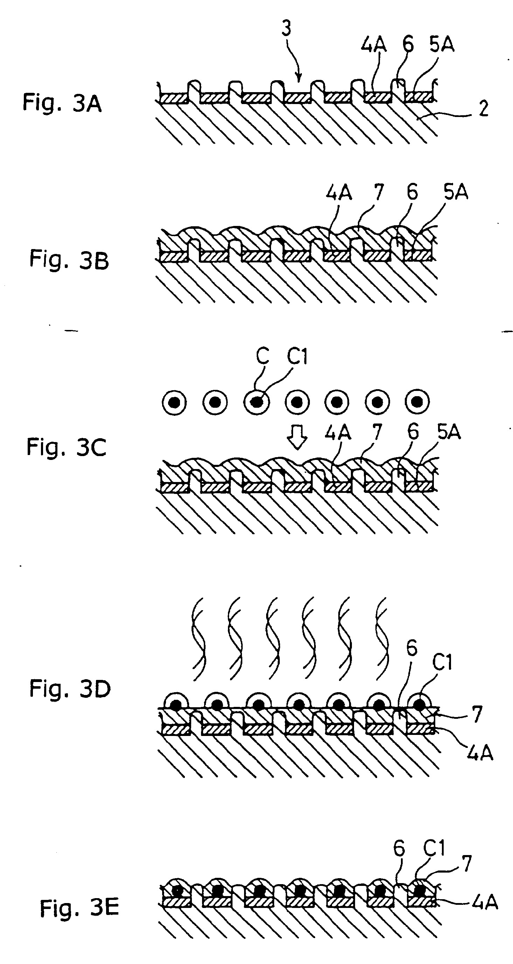

(1) In Fig. 3A, the connection sections 4A of terminals are placed on the bottoms of the grooves 5A.
   In Fig. 3B, cream solder 7 is applied to the arranging surface 3. The amount of cream solder applied is set such that the cream solder between adjacent ribs 6 is sufficient to solder a core wire to the connection section. If the height of ribs 6 is set such that the amount of cream solder in the groove 5 is equal to such an amount as described above, then it is sufficient that cream solder is applied up to the height of ribs 6.
(2) In Fig. 3C, the core wires C1 of a cable C, from which predetermined lengths of sheath are removed, are brought to the positions above the cream solder 7 corresponding to the connection sections 4A.
(3) In Fig. 3D, the cream solder 7 is heated so that it flows around the core wires C1 and retreats from the ribs 6 by action of the surface tension.

In Fig. 3E, after cooled, the solder is separated by the ribs 6 and the respective core wires C1 are soldered to the corresponding connection sections 4A without making any short-circuit.

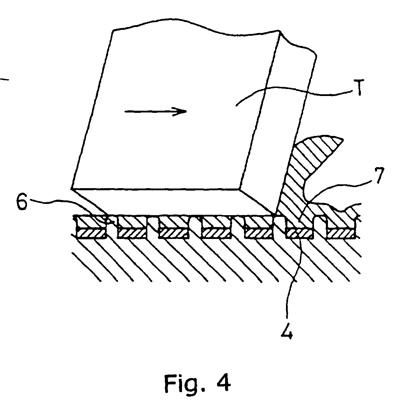

It is important to determine the appropriate amount of cream solder applied. Appropriate amounts of cream solder are not always applied evenly. As shown in Fig. 4, a relatively large amount of cream solder 7 is applied, and excessive cream solder is removed by a blade-like tool T before arrangement of core wires and heating, thereby ensuring the more accurate amount of cream solder applied.

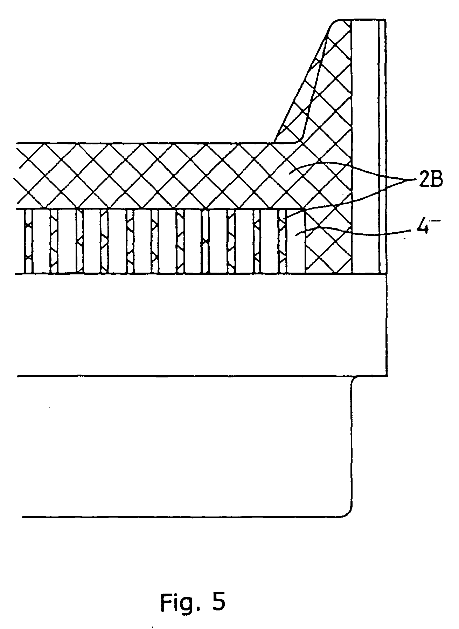

In Fig. 5, resist is applied to housing part 2B (including the ribs 6) around the connection sections 4 to prevent adherence of cream solder, thus ensuring prevention of short-circuiting by solder between adjacent connection sections. Resist may be applied to only the top faces of ribs to produce similar effects.

As has been described above, according to the invention, ribs are provided on the terminal arranging face of a housing to form grooves for receiving the connection sections of respective terminals so that when the core wires of a cable are soldered to the connection sections, the cream solder is separated by the ribs for each groove. In addition, a satisfactory amount of cream solder is applied at once to respective connection sections, thus providing a reliable simple soldering method.

## Claims

1. An electrical connector (1) comprising:
an insulating housing (2) having at least one terminal arranging face (3);
a plurality of terminals having flat connection sections (4) to be connected to a cable (C) arranged on said terminal arranging face (3);
a plurality of ribs (6) provided on said terminal arranging face (3) to form a plurality of grooves (5) in which said connection sections (4) to be connected to said cable (C) are provided separately;
and **characterised in that**
the width of said flat connection sections (4) is greater then the distance between the top face of said flat connection sections (4) and the top of said ribs (6); and
said ribs (6) having substantially the same height of a core wire (C1) of said cable (C) when arranged on said flat connection sections (4).

2. An electrical connector (1) according to claim 1, wherein the height of an appropriate cream solder (7) amount provided in each of said grooves (5) rises above the height of said ribs (6).

3. A method of soldering a cable to an electrical connector (1) according to claim 1, comprising the steps of:
applying cream solder to said connection sections (4) of said connector (1);
removing part of cream solder (7) which is beyond said ribs;
removing a predetermined length of sheath from an end portion of a cable to expose at least one core wire;
bringing said core wire to a position above said cream solder corresponding to one of said connection sections (4);
heating said cream solder so that the cable sinks into solder to solder said core wire to said one connection section (4); and
wherein the solder sets into terminal arranging face (3) around the wire and retreating from ribs (6) by action of surface tension.

4. A method according to claim 3, which further comprises, prior to said cream solder application step, the step of applying resist to areas around said connection sections (4) to prevent adherence of cream solder (7).

5. A method according to claim 4, wherein said areas are top faces of said ribs (6).

## Patentansprüche

1. Elektrischer Verbinder (1), mit:
einem isolierenden Gehäuse (2) mit wenigstens einer Oberfläche (3) zur Anordnung eines Anschlusses;
einer Vielzahl von Anschlüssen mit flachen Verbindungsabschnitten (4) zur Verbindung mit einem Kabel (C), dass auf der Oberfläche (3) angeordnet ist;
einer Vielzahl von Rippen (6), die auf der Oberfläche (3) angeordnet sind, so dass eine Vielzahl von Kerben (5) ausgebildet sind, in die die Verbindungsabschnitte (4) voneinander getrennt angeordnet sind;
**dadurch gekennzeichnet, dass**
die Breite der flachen Verbindungsabschnitte (4) ist größer als der Abstand zwischen der Oberseite der flachen Verbindungsabschnitte (4) und der Oberseite der Rippen (6); und
die Rippen (6) haben im wesentlichen die gleiche Höhe wie ein auf den flachen Verbindungsabschnitten angeordneter innerer Draht (C1) des Kabels (C).

2. Elektrischer Verbinder (1) nach Anspruch 1, wobei die Höhe eines geeigneten Lötmaterials (7) in jeder der Kerben (5) über die Höhe der Rippen (6) ragt.

3. Verfahren zum Löten eines Kabels an einen elektrischen Verbinder (1) nach Anspruch 1, mit den Schritten:
Aufbringen von Lötmaterial auf die Verbindungsabschnitte (4) des Verbinders (1);
Entfernen des Teils des Lötmaterials der über die Rippen hinausragt;
Entfernen einer vorbestimmten Länge der Hülle eines Endabschnitts eines Kabels,
so dass wenigstens ein innerer Draht frei liegt;
Anordnung des inneren Drahts an einer Position oberhalb des Lötmaterials und korrespondierend mit einem der Verbindungsabschnitte (4);
Erhitzung des Lötmaterials, so dass das Kabel in das Lötmaterial sinkt und der innere Draht mit einem der Verbindungsabschnitte (4) verlötet ist; und wobei das Lötmaterial härtet um den Draht in der Oberfläche (3) aus und zieht sich aufgrund von Oberflächenspannung von den Rippen (6) zurück.

4. Verfahren nach Anspruch 3, außerdem mit:
vor dem Schritt des Aufbringens von Lötmaterial wird Lack auf die Bereiche um die Verbindungsabschnitte (4) aufgebracht, um Anhaftung des Lötmaterials (7) zu vermeiden.

5. Verfahren nach Anspruch 4, wobei die Bereiche Oberflächen der Rippen (6) sind.

## Revendications

1. Connecteur électrique (1) comprenant :
un boîtier isolant (2) ayant au moins une face d'agencement de bornes (3) ;
une pluralité de bornes ayant des parties de connexion plates (4) à connecter à un câble (C) placé sur la dite face d'agencement de bornes (3) ;
une pluralité de nervures (6) prévues sur la dite face d'agencement de bornes (3) pour définir une pluralité de rainures (5) dans lesquelles les dites parties de connexion (4) à connecter au dit câble (C) sont placées séparément ;
**caractérisé en ce que** :
la largeur des dites parties de connexion plates (4) est plus grande que la distance entre la face supérieure des dites parties de connexion plates (4) et le dessus des dites nervures (6) ; et
les dites nervures (6) ont sensiblement la même hauteur qu'un fil d'âme (C1) du dit câble (C) lorsque celui-ci est posé sur les dites parties de connexion plates (4).

2. Connecteur électrique (1) selon la revendication 1, dans lequel la hauteur d'une quantité appropriée d'une pâte de soudure (7) prévue dans chacune des dites rainures (5) s'élève au-dessus de la hauteur des dites nervures (6).

3. Procédé de soudage d'un câble à un connecteur électrique (1) selon la revendication 1 ; comprenant les étapes de :
application de pâte de soudage aux dites parties de connexion (4) du dit connecteur (1) ;
enlèvement de la portion de pâte de soudage (7) qui est au-delà des dites nervures ;
enlèvement d'une longueur prédéterminée de gaine d'une partie d'extrémité d'un câble de manière à découvrir au moins un fil d'âme ;
amenée du dit fil d'âme à une position, au-dessus de la dite pâte de soudage, correspondant à une des dites parties de connexion (4) ;
chauffage de la dite pâte de soudage de sorte que le câble s'enfonce dans la matière de soudage de façon à souder le dit fil d'âme à la dite une partie de connexion (4) ; et
dans lequel la matière de soudage durcit dans la dite face d'agencement de bornes (3) autour du fil et vient en retrait par rapport aux nervures (6) du fait de la tension de surface.

4. Procédé selon la revendication 3, qui comprend en outre, avant la dite étape d'application de pâte de soudage, l'étape d'application d'une matière protectrice aux régions autour des dites parties de connexion (4), afin d'empêcher l'adhérence de la pâte de soudage (7).

5. Procédé selon la revendication 4, dans lequel les dites régions sont les faces supérieures des dites nervures (6).
